## Europäisches Patentamt

## European Patent Office

## Office européen des brevets

(19)

(11) Veröffentlichungsnummer: **0 223 066**
**B1**

(12)

# EUROPÄISCHE PATENTSCHRIFT

(45) Veröffentlichungstag der Patentschrift:
**31.05.89**

(21) Anmeldenummer: **86114281.8**

(22) Anmeldetag: **15.10.86**

(51) Int. Cl.⁴ **B 23 K 26/06,** B 23 K 1/00,
H 05 K 3/34

(54) **Vorrichtung zum Auflöten elektronischer Bauelemente auf eine Schaltungsplatine.**

(30) Priorität: **11.11.85 DE 3539933**

(43) Veröffentlichungstag der Anmeldung:
**27.05.87 Patentblatt 87/22**

(45) Bekanntmachung des Hinweises auf die Patenterteilung:
**31.05.89 Patentblatt 89/22**

(84) Benannte Vertragsstaaten:
**AT BE CH DE ES FR GB IT LI NL SE**

(56) Entgegenhaltungen:
EP-A-0 013 345
FR-A-2 434 002
US-A-4 020 319

(73) Patentinhaber: **Nixdorf Computer Aktiengesellschaft, Fürstenallee 7, D-4790 Paderborn (DE)**

(72) Erfinder: **Langhans, Lutz, Dr., Fasanenweg 25, D-8130 Starnberg (DE)**
Erfinder: **Meyer, Friedrich G., Bäckergasse 19, D-8137 Berg (DE)**
Erfinder: **Drake, Johannes, Am Richterbusch 18, D-4790 Paderborn (DE)**

(74) Vertreter: **Schaumburg, Thoenes & Englaender, Mauerkircherstrasse 31 Postfach 86 07 48, D-8000 München 80 (DE)**

EP 0 223 066 B1

## Beschreibung

Die Erfindung betrifft eine Vorrichtung zum gleichzeitigen Auflöten von mindestens zwei Anschlußelementen eines elektronischen Bauelementes auf eine Schaltungsplatine, umfassend eine Werkstückauflage, einen Laser zur Erzeugung der Lötenergie, wobei zwei Lötstrahlen von mindestens annähernd gleicher Intensität vorgesehen sind, in deren Weg jeweils eine Optik zur Fokussierung und Ausrichtung der Lötstrahlen auf die Lötstellen angeordnet ist, und Mittel zur Erzeugung einer Relativbewegung zwischen den Lötstrahlen und der Werkstückauflage.

Das Auflöten von elektronischen Bauelementen auf Schaltungsplatinen mit Hilfe eines Laserstrahles hat den Vorteil, daß durch den scharf fokussierten Laserstrahl nur die Lötstelle erwärmt wird, so daß eine globale Erwärmung der Schaltungsplatine und/oder der einzelnen elektronischen Bauelemente und damit eine potentielle Gefährdung derselben durch Überhitzung vermieden werden kann. Aus diesen Gründen wäre das Laserlötverfahren insbesondere geeignet für die Befestigung von elektronischen Bauelementen nach der SMD (Surface Mounted Device)-Technik. Ferner besteht die Möglichkeit, mit dem scharf fokussierten Laserstrahl auch an schwer zugängliche Lötstellen zu gelangen. Bei den bisher bekannten Laserlötverfahren, bei denen die Lötstellen nacheinander von einem Laserstrahl abgefahren werden, nimmt die Bestückung von Schaltungsplatinen mit Bauelementen, die eine Vielzahl von Beinchen aufweisen, eine erhebliche Zeit in Anspruch. Man hat bereits versucht, diesem Nachteil dadurch abzuhelfen, daß mit mehreren Laserstrahlen oder Lötstrahlengleichzeitig gearbeitet wird. Dabei wird der aus einem Laser austretende Strahl durch Strahlteiler in eine Mehrzahl von Einzelstrahlen aufgeteilt, wie dies z. B. aus der DE-OS-2 934 407 für eine Vorrichtung der eingangs genannten Art der Fall ist. Es hat sich jedoch in der Praxis gezeigt, daß es fast unmöglich ist oder einen großen technischen Aufwand erfordert, eine auch nur annähernd genaue Gleichverteilung der Energie auf die verschiedenen Teilstrahlen zu erreichen. Die Lötstrahlen müssen jedoch gleiche Intensität besitzen, da sonst unter dem einen Lötstrahl die Bauteile oder die Platine verbrennen, während die Intensität des anderen Lötstrahles unter Umständen nicht ausreicht, um eine befriedigende Lötverbindung zu erreichen. Für jeden Lötstrahl einen eigenen Laser zu verwenden, wäre jedoch zu aufwendig. Zum anderen sind die Einzelstrahlen fest ausgerichtet, so daß die Vorrichtung beim Übergang zu Bauteilen anderer Größe oder mit anderen Beinchenabständen neu justiert werden muß. Diese Vorrichtung ist somit für den praktischen Gebrauch nicht flexibel genug.

Der Erfindung liegt die Aufgabe zugrunde, eine Vorrichtung der eingangs genannten Art anzugeben, bei der mit vergleichsweise geringem Aufwand eine derartige Leistungssteigerung erzielt wird, daß das Laserlötverfahren auch zur Massenbestückung von Schaltungsplatinen mit elektronischen Bauelementen verwendet werden kann.

Diese Aufgabe wird erfindungsgemäß dadurch gelöst, daß der Resonator des Lasers zur Erzeugung der beiden Lötstrahlen an seinen beiden Längsenden mit je einem teildurchlässigen Spiegel abgeschlossen ist und daß zur Erzeugung der Relativbewegung und zur Ausrichtung der Lötstrahlen jeweils eine Ablenkvorrichtung vorgesehen ist, die zwei durch eine Steuervorrichtung unabhängig voneinander verstellbare Spiegel zur betriebsmäßigen Ablenkung des jeweiligen Lötstrahles aufweist.

Bei der erfindungsgemäßen Lösung werden auf einfache Weise mit einem einzigen Laser zwei Teilstrahlen gleicher Intensität erzeugt, mit denen gleichzeitig gelötet werden kann. Da im Gegensatz zu der aus der DE-OS-2 934 407 bekannten Vorrichtung bei der erfindungsgemäßen Lösung nicht das Bauelement relativ zu den fest justierten Lötstrahlen, sondern diese relativ zum Bauelement bewegbar sind, kann ein Bauelement mit mindestens zwei Reihen von Anschlußelementen in einem Bruchteil der hierfür bisher benötigten Zeit angelötet werden.

Vorzugsweise sind die Ablenkvorrichtungen beidseits der Werkstückauflage einander diametral gegenüberliegend derart angeordnet, daß die Lötstrahlen in ihrer Ruhestellung schräg zur Werkstückauflage und unter einem Winkel gegeneinander gerichtet sind. Diese Anordnung ermöglicht auch das Auflöten von Bauelementen nach der SMD-Technik, bei denen die Beinchen praktisch nicht über die Grundfläche des Bauelementes vorstehen und die Lötstellen bei einer senkrechten Ausrichtung des Lötstrahles relativ zur Werkstückauflagefläche gar nicht erreicht werden können.

Mit der fortschreitenden Miniaturisierung der integrierten Schaltungen gibt es immer mehr Bauelemente, die nicht nur an zwei einander gegenüberliegenden Seiten sondern auch an allen vier Seiten mit Kontaktbeinchen versehen sind. Um auch in diesem Falle mit nur zwei Lötstrahlen rasch und rationell arbeiten zu können, sind gemäß einer besonders bevorzugten Ausführungsform der Erfindung die Ablenkvorrichtungen derart angeordnet, daß die beiden Lötstrahlen in ihrer jeweiligen Ruhelage jeweils in einer senkrecht zur Werkstückauflagefläche und schräg zur Werkstückvorschubrichtung gerichteten Ebene liegen. Das hat zur Folge, daß die üblicherweise quaderförmigen und mit ihren Kanten parallel zu den Kanten der Schaltungsplatinen ausgerichteten Bauelemente annähernd diagonal zwischen den beiden Lötstrahlen zu liegen kommen. Werden die Lötstrahlen in ihrer jeweiligen Ruhelage jeweils annähernd auf eine Ecke des betreffenden Bauelementes gerichtet, so kann jeder Lötstrahl ausgehend von dieser Ruhelage die beiden in der betreffenden Ecke zusammentreffenden rechtwinklig zueinander gerichteten Reihen von Beinchen überstreichen, ohne daß eine Verstellung des Werkstückes oder der Ablenkvorrichtungen erforderlich wäre. Eine derartige Verstellung würde eine erhebliche Zeit benötigen.

Eine weitere Verkürzung der Lötzeit und damit eine Produktionssteigerung kann durch eine Steigerung der Leistung des Lötstrahles erreicht werden. Dies ist jedoch nicht ohne weiteres möglich, da sonst die Gefahr besteht, daß der Lötstrahl die Anschlüsse des Bauelementes oder die Platine verbrennt. Zur Beseitigung dieser Schwierigkeit wird erfindungsgemäß vorgeschlagen, daß die Spiegel derart steuerbar sind, daß der Auftreffpunkt des Laserstrahles auf dem Werkstück innerhalb des Bereiches einer Lötstelle bzw. bei seiner Bewegung entlang einer vorgegebenen Bahn eine gegenüber seiner Verweilzeit im Bereich einer Lötstelle bzw. gegenüber seiner Bewegungsgeschwindigkeit entlang der Bahn rasche Pendelbewegung ausführt. Dadurch kann die Leistung des Lötstrahles erheblich erhöht werden, ohne daß die Gefahr einer Verbrennung der Anschlüsse oder der Platine besteht. Dies läßt eine deutliche Steigerung der Lötgeschwindigkeit zu. Die Steuerung der Spiegel in der Weise, daß der Lötstrahl die gewünschte Pendelbewegung ausführt, läßt sich dabei auf verschiedene Weise erreichen. Beispielsweise kann das Steuerprogramm, das die Bewegung der Spiegel bestimmt, entsprechend gestaltet werden.

Um das Laserlötverfahren für die Massenbestückung von Platinen mit Bauelementen einsetzen zu können, ist ein automatischer und exakter Vorschub des Werkstückes durch die Löteinrichtung erforderlich. Während des Anlötens der Anschlußelemente eines Bauelementes bleibt bei der erfindungsgemäßen Lösung das Werkstück in Ruhe, da die Lötstrahlen durch die Ablenkspiegel an der jeweiligen Beinchenreihe des Bauelementes entlang geführt werden, wobei der Lötstrahl beim Übergang von einem Beinchen zum nächsten Beinchen nicht abgeschaltet wird. Ein Vorschub des Werkstückes erfolgt jedoch beim Übergang von einem Bauelement zum nächsten Bauelement, wobei der Lötstrahl während dieser Verstellung unterbrochen wird. Zum Vorschub des Werkstückes ist dabei die Werkstückauflage in an sich bekannter Weise mittels eines Stellantriebes parallel zu ihrer Werkstückauflagefläche verstellbar. Die Positionierung der Bauelemente in ihrer jeweiligen Lötstellung und die Ablenkung der Lötstrahlen erfolgt dabei über eine Steuereinrichtung mit Hilfe eines Steuerprogrammes, wobei die für die Positionierung der Bauelemente und die Ablenkung der Lötstrahlen erforderlichen Koordinaten erfindungsgemäß in der Weise gewonnen werden, daß durch Verstellen der Schaltungsplatine jedes Bauelement in seine Lötstellung gebracht und die dieser Stellung entsprechenden Koordinaten ermittelt und gespeichert werden. Anschließend werden die einzelnen Lötstellen des jeweiligen Bauelementes in seiner Lötstellung mit dem durch eine Abblendvorrichtung abgeschwächten und manuell fortschaltbaren Laserstrahl abgetastet und die Koordinaten der der jeweiligen Lage des Laserstrahles an jeder Lötstelle entsprechenden Spiegelstellung ermittelt und gespeichert. Soll eine große Anzahl gleichartiger Schaltungsplatinen verarbeitet werden, so werden an einer Musterplatine in der vorstehend beschriebenen Weise die Koordinaten der Bauelemente und ihrer Lötstellen ermittelt. Da die Bestückung der Schaltungsplatine mit den Bauelementen und ihrer Positionierung relativ zu den Ablenkvorrichtungen der Löteinrichtung in der Regel mit hinreichend großer Genauigkeit und Reproduzierbarkeit erfolgen kann, kann anschließend die Bearbeitung der weiteren Schaltungsplatinen nach den nunmehr vorliegenden Koordinaten selbsttätig erfolgen. Auf diese Weise kann jede beliebige Anordnung von Bauelementen auf einer Schaltungsplatine exakt gespeichert werden. Dieses Verfahren zum Ermitteln und Speichern von Koordinaten für die Bearbeitung eines Werkstückes mittels eines ablenkbaren Laserstrahles ist nicht auf die Verwendung in Verbindung mit dem vorstehend beschriebenen Lötverfahren beschränkt sondern auch universeller verwendbar.

Die empfindlichsten Elemente der beschriebenen Laserlöteinrichtung sind die verwendeten Spiegelgalvanometer zur Ablenkung der Lötstrahlen. Auch gleichartige Galvanometer sind von Ausführung zu Ausführung geringfügig verschieden und erleiden darüber hinaus beim Aus- und Einschalten unter Umständen eine Nullpunktsverschiebung.

Daher ist es zweckmäßig, wenn eine Möglichkeit zur Überprüfung der tatsächlichen Lage der Lötstellen auf dem Werkstück, zur Justierung des Galvanometers und gegebenenfalls auch zur Ermittlung eines Skalenfaktors für die Koordinaten der Lötstellen besteht. Erfindungsgemäß wird hierzu vorgeschlagen, daß in einer vorgegebenen Position der Schaltungsplatine auf dieser mit dem abgeschwächten Lötstrahl mindestens eine Referenzmarke abgetastet und die dem Auftreffen des Lötstrahles auf der Referenzmarke entsprechende Ist-Stellung der Spiegel mit einer Soll-Stellung derselben verglichen wird und daß bei Abweichungen zwischen Ist- und Soll-Stellung eine entsprechende Nachjustierung der Galvanometer und oder eine Nullpunktskorrektor für die den Koordinaten der Lötstellen entsprechenden steuerdaten erfolgt. Durch Abtasten mehrerer Referenzmarken ist es möglich, auch gegebenenfalls einen Skalenfaktor zu ermitteln. Das gibt die Möglichkeit, nicht nur auf einfache Weise die Galvanometer nach einer Betriebsunterbrechung an demselben Gerät nachzujustieren, sondern auch mit demselben Betriebsprogramm auf verschiedenen Lötvorrichtungen zu arbeiten, deren Galvanometer sich geringfügig voneinander unterscheiden.

Weitere Merkmale und Vorteile der Erfindung ergeben sich aus der folgenden Beschreibung, welche in Verbindung mit den beigefügten Zeichnungen die Erfindung anhand eines Ausführungsbeispieles erläutert. Es zeigen:

Fig. 1 eine schematische Draufsicht auf eine erfindungsgemäße Lötvorrichtung,

Fig. 2 eine schematische Seitenansicht der Werkstückauflage mit den Ablenkvorrichtungen in Richtung des Pfeiles A in Fig. 1 und

Fig. 3 eine schematische Skizze zur Erläuterung der Funktionsweise der Ablenkvorrichtungen.

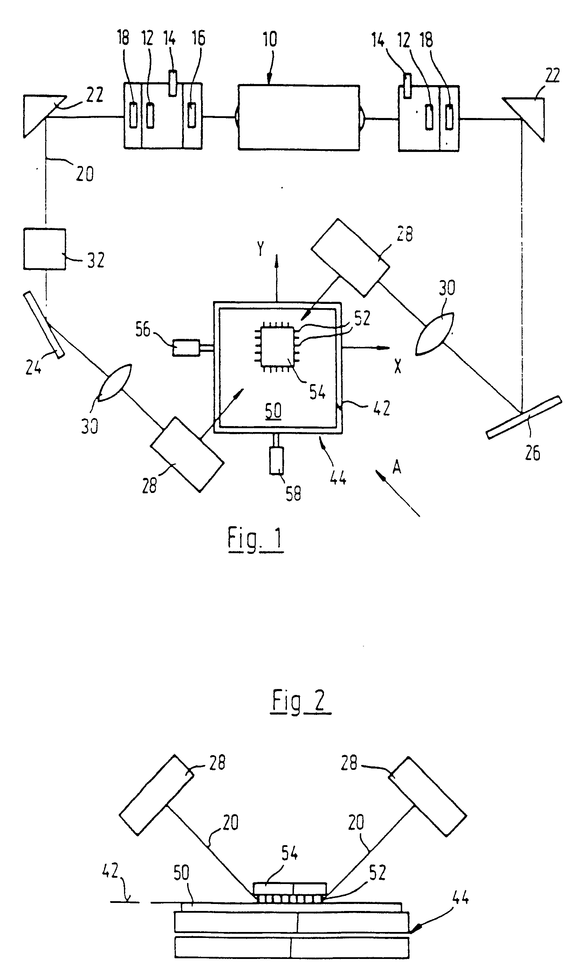

In Fig. 1 ist mit 10 ein Laser bezeichnet, bei dem es sich beispielsweise um einen YAG-Laser handeln kann. Der Resonator des Lasers 10 ist an beiden Enden durch schematisch angedeutete teildurchlässige Spiegel 12 abgeschlossen, die jeweils etwa zehn Prozent der Energie austreten lassen. Innerhalb des Resonators vor jedem Spiegel 12 ist ein Fallverschluß 14 vorgesehen, der sich bei einer Störung automatisch in den Strahlengang schiebt und damit das Austreten von Energie aus dem Laser verhindert. Ebenfalls innerhalb der Resonatorstrecke befindet sich ein mechanischer Schalter 16, mit dem der Aufbau der Laserenergie unterbrochen, d. h. der Laser vollständig abgeschaltet werden kann.

Außerhalb der Resonatorstrecke schließt sich an jeden Spiegel 12 ein Schalter 18 an, mit dem der jeweilige Teilstrahl oder Lötstrahl 20 für sich unterbrochen werden kann. Dieser Schalter 18 ist jeweils so ausgelegt, daß er die aus dem Spiegel 12 austretende Energie auffangen kann. Die beiden Teilstrahlen 20 werden dann über Spiegel 22 und 24 bzw. 22 und 26 zu Ablenkvorrichtungen 28 gelenkt, wobei die genaue Anzahl und Anordnung der Spiegel von der Geometrie der Gesamtanordnung abhängt. In dem Strahlengang ist ferner jeweils eine durch eine Linse 30 schematisch angedeutete Optik zur gegebenenfalls erforderlichen Fokusanpassung und zur Einstellung der Tiefenschärfe angeordnet. Im Strahlengang des in der Fig. 1 links dargestellten Teilstrahles 20 ist ferner ein Strahlregler 32 angeordnet, um die beiden Teilstrahlen 20 hinsichtlich ihrer Intensität exakt aufeinander abstimmen zu können.

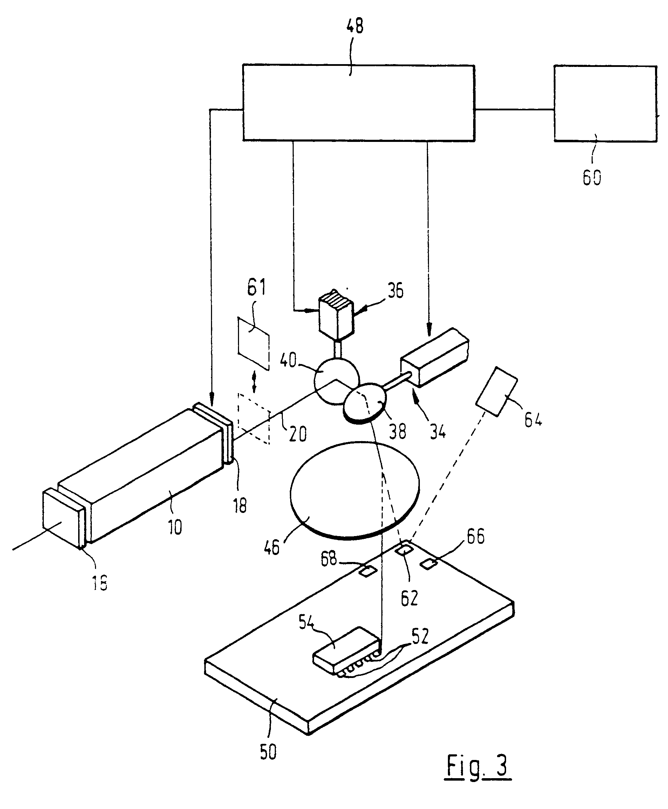

Die jeweilige Ablenkvorrichtung 28 umfaßt gemäß Fig. 3 in an sich bekannter Weise zwei Galvanometer 34 und 36, mit deren Spiegeln 38 bzw. 40 der Teilstrahl in einer beliebigen Richtung abgelenkt werden kann. Das Feld, das der Strahl dabei auf der Oberfläche 42 eines Werkstückauflagetisches 44 überstreicht, hängt unter anderem auch von dem gewählten Objektiv 46 am Ausgang der Ablenkvorrichtung 28 ab.

Die Galvanometer 34 und 36 werden von einer Steuervorrichtung 48 gesteuert, um Richtung und Länge der Auslenkung des Lötstrahles 20 auf der Werkstückoberfläche zu bestimmen. Die Steuerung erfolgt dabei beispielsweise mit einem geeigneten Steuerprogramm in der Weise, daß der jeweilige Lötstrahl eine schnelle vorzugsweise irreguläre Pendelbewegung geringer Amplitude ausführt. Infolgedessen bewegt sich der Auftreffpunkt des Lötstrahles auf eiper Schaltungsplatine 50 innerhalb des Bereiches einer Lötstelle bzw. der von Lötstelle zu Lötstelle führenden Bewegungsbahn nach einem bestimmten oder zufälligen Bewegungsmuster. Dadurch kann die Leistung des Lötstrahles erhöht werden, ohne daß ein Verbrennen der Beinchen 52, eines Bauelementes 54 oder der Schaltungsplatine 50 zu befürchten ist. Die Steuervorrichtung steuert ferner die Antriebe 56 und 58 des Werkstückauflagetisches 44 zu dessen Verstellung in x-Richtung bzw. y-Richtung sowie die Schalter 18, mit denen die einzelnen Lötstrahlen 20 abgeschaltet werden können. Mit Hilfe der Ablenkvorrichtungen 28 können somit die beiden Teil- oder Lötstrahlen an den Beinchen 52 eines Bauelementes 54 entlang geführt werden, das sich auf einer auf dem Werkstückauflagetisch 44 liegenden Schaltungsplatine 50 befindet. Der jeweilige Lötstrahl 20 wird dabei beim Übergang von einem Beinchen 52 zum nächsten nicht abgeschaltet, sondern erst am Ende der Reihe.

Wie man in Fig. 2 erkennt, sind die Ablenkvorrichtungen 28 relativ zum Werkstückauflagetisch 44 derart angeordnet, daß die Lötstrahlen 20 schräg zur Oberfläche 42 des Werkstückauflagetisch 44 und unter einem Winkel gegeneinander gerichtet sind. Dadurch bietet sich die Möglichkeit, auch Bauelemente auf Schaltungsplatinen aufzulöten, deren Beinchen wie in dem in der Fig. 2 dargestellten Fall nicht über die Grundfläche des Bauelementes hinausragen.

In der Fig. 1 ist eine Anordnung dargestellt, bei der die Ablenkvorrichtungen 28 relativ zu dem anzulötenden Bauelement 54 so angeordnet sind, daß die Lötstrahlen 20 in ihrer Ruhestellung in einer senkrecht zur Oberfläche 42 des Werkstückauflagetisches 44 gerichteten und diagonal durch das Bauelement 54 verlaufenden Ebene liegen. Dies bietet die Möglichkeit, bei einem Bauelement, das wie in dem in Fig. 1 dargestellten Fall an allen vier Seiten jeweils eine Reihe von Beinchen aufweist, mit einem Lötstrahl 20 ausgehend von einer Ecke des Bauelementes 54 zwei orthogonal zueinander verlaufende Reihen von Beinchen 52 zu überstreichen und damit anzulöten. Eine Verstellung desselben Bauelementes 54 relativ zu den Ablenkvorrichtungen 28 ist dabei nicht erforderlich. Eine Verstellung der Schaltplatine 50 relativ zu den Ablenkvorrichtungen 28 erfolgt erst beim Übergang von einem Bauelement zum nächsten.

Zur Automatisierung des Lötvorganges ist es erforderlich, der Steuervorrichtung die entsprechenden Koordinaten der Bauelemente relativ zu den Ablenkvorrichtungen und die Steuergrößen für die Spiegel einzugeben, um die Lötstrahlen an dem jeweiligen Bauelement von Lötstelle zu Lötstelle zu führen. Dies erfolgt in der Weise, daß nach einer Positionierung der Schaltungsplatine 50 auf dem Werkstückauflagetisch 44 dieser mit Hilfe seiner Antriebe 56 und 58 so verstellt wird, daß das jeweilige Bauelement in einer geeigneten Lötstellung relativ zu den Ablenkvorrichtungen 28 steht. Die dieser Stellung des Bauelementes entsprechenden Koordinaten des Werkstückauflagetisches werden mittels eines Bedienungsgerätes 60 der Steuervorrichtung 48 eingegeben und in dieser gespeichert. Bei ruhendem Bauelement werden nun die zu dem Bauelement gehörenden Lötstellen mit Hilfe des jeweiligen Laserstrahles 20 abgetastet, dessen Intensität durch eine schematisch angedeutete in den Strahlenweg einstellbare Abblendvorrichtung 61 soweit herabgesetzt werden kann, daß die Strahlleistung weder zum Löten ausreicht noch die Gefahr einer Verbrennung des Materials besteht. In der Praxis ist es vorteilhaft, die Abblendvorrichtung innerhalb des Resonators des Lasers 10 anzuordnen, um Ablenkfehler des Strahles 20 durch optische Elemente der Abblendvorrichtung zu vermeiden. Auch wenn der Strahl des im vorliegenden Falle verwendeten Lasers für das Auge nicht sichtbar ist, kann sein Auftreffort auf dem Werkstück 50 doch mit Hilfe einer geeigneten nicht dargestellten Kamera sichtbar gemacht werden. Der abgeschwächte Laserstrahl wird nun mit Hilfe des Bedienungsgerätes 60 und der Steuervorrichtung 48 manuell von Lötstelle zu Lötstelle fortgeschaltet. Die dem Auftreffen des abgeschwächten Laserstrahls auf der jeweiligen Lötstelle entsprechende Stellung der Galvanometerspiegel 38 und 40 bzw. die dieser Stellung entsprechenden Steuerdaten werden in einem geeigneten Speicher der Steuervorrichtung 48 gespeichert. Wenn somit sämtliche Koordinaten und Steuergrößen für eine bestimmte Schaltungsplatine bestimmt sind, kann das Auflöten der Bauelemente auf gleichartigen Schaltungsplatinen automatisch erfolgen. Bei Geräten, die einen Laser hoher Leistung verwenden, ist es bekannt, zur Justierung der optischen Komponenten einen Pilotstrahl koaxial zum Arbeitsstrahl einzublenden. Dabei sind kleine Abweichungen zwischen Pilotstrahl und Arbeitsstrahl nicht immer ganz auszuschließen. Diese mögliche Fehlerquelle kann durch die Verwendung des in seiner Intensität abgeschwächten Arbeits- oder Originalstrahles zur Abtastung der Lötstellen bei der vorliegenden Lösung vollständig ausgeschlossen werden.

Bei den geringen Abmessungen der Lötstellen und ihrer gegenseitigen Abstände ist eine hohe Genauigkeit bei der Steuerung der Lötstrahlen erforderlich. Weder bei den einzelnen Bauelementen noch bei der Bestückung der Platinen können kleine Abweichungen ganz ausgeschlossen werden. Auch verhalten sich die Galvanometer 34 und 36 trotz gleichen Aufbaues nicht völlig identisch. Ferner kann beim Einschalten der Galvanometer nach einer längeren Betriebsunterbrechung ihr Nullpunkt verstellt sein. Daher ist es vorteilhaft, wenn eine Möglichkeit besteht, einerseits die gespeicherten Koordinaten der Lötstellen mit den tatsächlichen Koordinaten auf dem jeweiligen Werkstück zu vergleichen und andererseits die Galvanometer bezüglich der vorgegebenen Ausgangsstellung der Schaltungsplatine auf dem Werkstückauflagetisch nachzujustieren und gegebenenfalls auch einen Skalenfaktor zu ermitteln, so daß dasselbe Steuerprogramm mit denselben Werten der Koordinaten und Steuergrößen auch auf gleichartigen Löteinrichtungen verwendet werden kann Hierzu wird der abgeschwächte Lötstrahl auf eine erste Referenzmarke 62 gerichtet, die sich an einer bestimmten Stelle der in einer bestimmten Lage auf dem Werkstückauflagetisch 44 positionierten Platine befindet. Es kann dabei vorgesehen sein, daß der Lötstrahl selbsttätig die Referenzmarke 62 sucht. Das Auftreffen des Lötstrahles auf der Referenzmarke 62 wird von einem Empfänger 64 registriert. Ein Komparator in der Steuervorrichtung 48 vergleicht die entsprechende Ist-Stellung der Galvanometerspiegel 38 und 40 mit ihrer der Position der Referenzmarke 62 entsprechenden Soll-Stellung. Bei einer Abweichung können die Galvanometer 34 und 36 entsprechend nachjustiert werden. Eine Ermittlung eines geeigneten Skalenfaktors kann durch das Abtasten weiterer Referenzmarken 66 und 68 in der gleichen Weise erfolgen. Auch können die abgeschwächten Lötstrahlen 20 selbsttätig an den Lötstellen entlang geführt werden, wobei die an den Anschlußelementen reflektierten Strahlen aufgefangen werden. Hierzu dienen dem Empfänger 64 entsprechende nicht dargestellte Empfangselemente, die so angeordnet sind, daß die aus dem abzutastenden Bereich reflektierte Strahlung lückenlos erfaßt werden kann. Die Stellung der Ablenkvorrichtungen bei Empfang eines reflektierten Strahles wird mit den für die betreffende Lötstelle gespeicherten Steuerdaten verglichen, so daß diese gegebenenfalls korrigiert werden können.

Die vorstehend beschriebene Vorrichtung bzw. die zugehörigen Verfahrensschritte wurden im Zusammenhang mit dem Auflöten von elektronischen Bauteilen auf einer Schaltungsplatine beschrieben. Dieselben Verfahrensschritte und dieselbe Vorrichtung sind auch in anderen Fällen anwendbar, in denen eine Bearbeitung von Werkstücken mit Hilfe eines ablenkbaren Laserstrahles erfolgen soll.

## Patentansprüche

1. Vorrichtung zum gleichzeitigen Auflöten von mindestens zwei Anschlußelementen eines elektronischen Bauelementes auf eine Schaltungsplatine, umfassend eine Werkstückauflage, einen Laser zur Erzeugung der Lötenergie, wobei zwei Lötstrahlen von mindestens annähernd gleicher Intensität vorgesehen sind, in deren Weg jeweils eine Optik zur Fokussierung und Ausrichtung der Lötstrahlen auf die Lötstellen angeordnet ist, und Mittel zur Erzeugung einer Relativbewegung zwischen den Lötstrahlen und der Werkstückauflage, dadurch gekennzeichnet, daß der Resonator des Lasers (10) zur Erzeugung der beiden Lötstrahlen (20) an seinen beiden Längsenden mit je einem teildurchlässigen Spiegel (12) abgeschlossen ist und daß zur Erzeugung der Relativbewegung und zur Ausrichtung der Lötstrahlen (20) jeweils eine Ablenkvorrichtung (28) vorgesehen ist, die zwei durch eine Steuervorrichtung (48) unabhängig voneinander verstellbare Spiegel (38, 40) zur betriebsmäßigen Ablenkung des jeweiligen Lötstrahles (20) aufweist.

2. Vorrichtung nach Anspruch 1, dadurch gekennzeichnet, daß die Ablenkvorrichtungen (28) beidseitig der Werkstückauflage (44) einander diametral gegenüberliegend derart angeordnet sind, daß die Lötstrahlen (20) in ihrer Ruhestellung schräg zur Werkstückauflageebene (42) und unter einem Winkel gegeneinander gerichtet sind.

3. Vorrichtung nach Anspruch 2, dadurch gekennzeichnet, daß die Ablenkvorrichtungen (28) derart angeordnet sind, daß die beiden Lötstrahlen (20) in ihrer jeweiligen Ruhelage jeweils in einer senkrecht zur Werkstückauflageebene (42) und schräg zur Werkstückvorschubrichtung gerichteten Ebene liegen.

4. Vorrichtung nach einem der Ansprüche 1 bis 3, dadurch gekennzeichnet, daß die Spiegel (38, 40) derart steuerbar sind, daß der Auftreffpunkt des Laserstrahles auf dem Werkstück (50) innerhalb des Bereiches einer Lötstelle bzw. innerhalb einer vorgegebenen Bewegungsbahn eine gegenüber seiner Verweilzeit im Bereich einer Lötstelle bzw. gegenüber seiner Bewegungsgeschwindigkeit entlang der Bewegungsbahn rasche Pendelbewegung ausführt.

5. Vorrichtung nach einem der Ansprüche 1 bis 4, gekennzeichnet durch eine in den Weg des Laserstrahls einschaltbare Abblendeinrichtung (61) zur wahlweisen Schwächung der Strahlintensität und eine Einrichtung zur Ermittlung des tatsächlichen Auftreffortes des Lötstrahles (20) auf der Werkstückauflage (44) bzw. dem Werkstück (50), wobei die Steuervorrichtung (48) eine Einrichtung zur Ermittlung und Speicherung der Steuerdaten umfaßt, die vorgegebenen Auftrefforten des Lötstrahles (20) auf der Werkstückauflage (44) bzw. dem Werkstück (50) entsprechen.

6. Vorrichtung nach Anspruch 5, dadurch gekennzeichnet, daß die Abblendeinrichtung innerhalb des Resonators des Lasers (10) angeordnet ist.

7. Vorrichtung nach Anspruch 5 oder 6, dadurch gekennzeichnet, daß die Steuereinrichtung (48) einen Komperator zum Vergleich der vorgegebenen Steuerdaten entsprechenden Soll-Stellung der Ablenkvorrichtung und ihrer Ist-Stellung sowie eine Recheneinheit umfaßt, mit der die gespeicherten Steuerdaten in Abhängigkeit einer Abweichung zwischen Soll- und Ist-Stellung korrigierbar sind.

## Claims

1. A device for soldering simultaneously at least two connecting elements of an electronic component on a circuit board comprising a workpiece support, a laser for producing the soldering energy, two soldering beams being provided with at least approximately equal intensity, in the path of each beam being arranged an optic for focussing and aligning the soldering beams onto the soldering spots, and means for the production of a relative movement between the soldering beams and a workpiece support, characterized in that a resonator of the laser (10) for producing both soldering beams (20) is closed on both of its longitudinal ends by a semi-reflecting mirror (12) and that for the production of the relative movement and for the alignment of the soldering beams (20) there is a deflecting device (28) which has two mirrors (38, 40) which are adjustable independently from one another by a control device (48) for an operational deflection of the respective soldering beams (20).

2. A device according to claim 1, characterized in that the deflecting devices (28) are arranged on both sides of the workpiece support (44) and placed diametrically opposite to one another so that the soldering beams (20) are directed in their resting position obliquely to the workpiece support plane (42) and aligned at an angle to one another.

3. A device according to claim 2, characterized in that the deflecting devices (28) are arranged so that both soldering beams (20) are lying in their respective resting positions in a plane being vertical to the workpiece support plane (42) and obliquely to the workpiece advancing direction.

4. A device according to one of claims 1 to 3, characterrized in that the mirrors (38, 40) can be controlled so that the point of impact of the laser beam on the workpiece (50) performs within the area of a soldering spot or within a predetermined path of motion, a pendulum movement which is fast relative to its lingering period in the area of the soldering spot and relative to its velocity of movement along the path of motion, respectively.

5. A device according to one of claims 1 to 5, characterrized by a dimming device (61) adapted to be inserted in the path of the laser beam for selective weakening of the intensity of the beam, and a device for determining the actual point of impact of the soldering beam (20) on the workpiece support (44) and on the workpiece (50), respectively, the control device (48) comprising a device for determining and storage of the control data which correspond to predetermined points of impact of the soldering beam (20) on the workpiece support (44) and on the workpiece (50), respectively.

6. A device according to claim 5, characterized in that the dimming device is arranged within the resonator of the laser (10).

7. A device according to claims 5 or 6, characterized in that the control device (48) comprises a comparator for comparing the respective desired position of the deflecting device with its actual position, the desired position corresponding to predetermined control data, as well as a computing unit by which the stored control data can be corrected depending on a difference between the desired and the actual position.


**Revendications**

1. Equipement pour le soudage simultané sur un circuit imprimé de deux éléments au moins de connexion d'un composant électronique, comprenant un support de pièce, un laser pour engendrer l'énergie de soudage deux rayons de soudage, d'intensité au moins approximiativement égale, étant prévu sur le trajet de chacun desquels est disposée une optique pour focaliser et orienter les rayons de soudage sur les points de soudage, et des moyens pour produire un mouvement relatif entre les rayons de soudage et le support de pièce, caractérisé en ce que le résonateur du laser (10) pour la génération des deux rayons de soudage (20) est obturé à chacune de ses extrémités longitudinales par un miroir (12) semi-transparent et en ce que, pour la création du mouvement relatif et pour l'orientation des rayons de soudage (20), il est prévu un dispositif respectif de déviation (28) qui comprend deux miroirs (38, 40) réglables indépendamment l'un de l'autre à l'aide d'un dispositif de commande (48) pour une déviation fonctionnelle du rayon de soudage (20) concerné.

2. Equipement selon la revendication 1, caractérisé en ce que les dispositifs de déviation (28) sont disposés de part et d'autre du support de pièce (44) en étant diamétralement opposés l'un à l'autre de telle façon que, à leur position de repos, les rayons de soudage (20) sont dirigés obliquement par rapport au plan (42) du support de pièce et avec un certain angle l'un par rapport à l'autre.

3. Equipement selon la revendication 2, caractérisé en ce que les dispositifs de déviation (28) sont disposés de telle façon que, à leur position de repos, les deux rayons de soudage (20) sont situés l'un et l'autre dans un plan dirigé perpendiculairement au plan (42) du support de pièce et obliquement par rapport au sens d'avancement de la pièce.

4. Equipement selon l'une quelconque des revendications 1 à 3, caractérisé en ce que les miroirs (38, 40) sont commandables de telle façon que le point d'impact du rayon laser sur ta pièce (50) effectue à l'intérieur de la zone d'un point de soudage ou à l'intérieur d'une trajectoire prédéfinie du déplacement un mouvement pendulaire rapide par rapport à son temps de séjour dans la zone d'un point de soudage ou par rapport à sa vitesse de déplacement le long de sa trajectoire de déplacement.

5. Equipement selon l'une quelconque des revendications 1 à 4, caractérisé par un dispositif à diaphragme (61) pouvant être placé sur la trajectoire du rayon laser pour affaiblir à volonté l'intensité du rayon, et par un dispositif pour déterminer le point d'impact effectif du rayon de soudage (20) sur le support de pièce (44) ou sur la pièce (50), le dispositif de commande (48) comprenant un agencement pour déterminer et mettre en mémoire les données de commande qui correspondent à des points d'impact prédéfinis du rayon de soudage (20) sur le support de pièce (44) ou sur la pièce (50).

6. Equipement selon la revendication 5, caractérisé en ce que le dispositif à diaphragme est disposé à l'intérieur du résonateur du laser (10).

7. Equipement selon la revendication 5 ou 6, caractérisé en ce que le dispositif de commande (48) comprend un comparateur pour comparer la position réelle et la position de consigne du dispositif de déviation correspondante à des données de commande prédéfinies, ainsi qu'une calculatrice avec laquelle les données de commande mises en mémoire peuvent être corrigées en fonction d'un écart entre la position réelle et la position de consigne.

Fig. 1

Fig 2

Fig. 3